# EUROPEAN PATENT APPLICATION

(11) **EP 1 975 227 A1**
(43) Date of publication of application: **01.10.2008**
(21) Application number: 08005169.1
(22) Date of filing: 19.03.2008
(51) Int. Cl.: C11D 11/00, G03F 7/42, H05K 3/26, H01L 21/306, C11D 3/20, C11D 7/26, C11D 3/30, C11D 7/32, C11D 3/02, C11D 7/06, C11D 3/24, C11D 7/10, C11D 7/28, C11D 3/43, C11D 7/50

(54) **Semiconductor etch residue remover and cleansing compositions**

(30) Priority: 21.03.2007 US 688945
(71) Applicant: General Chemical Performance Products LLC, Parsippany NJ 07054 (US)
(72) Inventor: Rovito, Robert J., Quakertown, PA 18951 (US); Job, Francis W., Douglassville, PA 19518 (US); Lowalekar, Viral P., Hillsboro, OR 97124 (US); Muthukumaran, Ashok Kumar, Tuscon, AZ 85719 (US)
(74) Representative: Heusler, Wolfgang

(57) **Abstract**

An aqueous and semi-aqueous formulation useful for removing post etch and ash residue from Cu low K dielectric semiconductor devises. The composition comprises a polycarboxylic acid buffering system, a fluoride system, water, a water miscible organic solvent for the said aqueous compositions and optionally a chelating agent, a metal corrosion inhibitor and a surfactant.

## Description

### FIELD OF THE INVENTION

The present invention relates to a composition comprising a processing aid in the manufacture of semiconductor components and more particularly to aqueous and semi-aqueous residue removing compositions for semiconductor components as well as for cleansing free of residue, processing equipment and tools used in semiconductor manufacturing operations.

### BACKGROUND OF THE INVENTION

During the fabrication of semiconductor devices, plasma etching, ion milling, reactive ion etching, and similar techniques, are used to remove material from a substrate, resulting in an etched pattern on the substrate. This etching process generates complex residues, formed from the interaction of plasma gases, substrate and resist materials. These residues often stubbornly resist removal even by known rigorous means. It is crucial that the residues generated from the etch process be completely removed, with little or no significant damage or further etching of the underlying substrate. In some cases, this substrate may have more than one material exposed. For example, zero valent copper, organosilicate glass and tetraethylorthosilicate may all be present in the underlying substrate. Exposure to a liquid cleaner or residue remover can result in damage to one or more of these surfaces. Accordingly, it is desirable to have a cleaning solution that removes all unwanted residues without damaging the exposed components of the substrate. As device geometry shrinks with each new technology node, any ancillary etching of the components of the substrate takes on even greater importance.

Etch residue removers can be applied to a semiconductor wafer with a variety of tools. One method is to immerse a wafer or wafers, via a carrier, in a tank or sink of etch residue remover, at a fixed time and temperature. Subsequent rinsing and drying affords a clean semiconductor wafer ready for the next step in the manufacturing process. Other methods of application include spray tools, where the cleaner is sprayed onto rotating wafers, or single wafer tools, where the cleaner is applied directly to a single spinning wafer. Wafers are then rinsed and dried in a prescribed manner. Those skilled in the art will be familiar with the various iterations of cleaning tools and their manufacturers.

Cleaning formulations described in prior art use a variety of organic acids as buffers, mostly in a semi-aqueous fluoride matrix. These acids include acetic acid, lactic acid, formic acid, diacids such as adipic acid or malonic acid, and a variety of aminosulfonic acids. All of the above listed acids, and others, can provide a buffering effect defined as the ability to resist changes in pH when small amounts of acids or bases are added, or water is added or removed from the formulation. Buffers are most effective when the pH is set to within about 1 pH unit of the pKa value. For example, acetic acid has a pKa of 4.76. An effective buffer can be formed with acetic acid between the pH of about 3.75 and 5.75. Addition of small amounts of acid or base, or addition or removal of water from an acetic acid buffer prepared in this range will not substantially change the pH. Similarly, polyprotic carboxylic acids have been shown to form an effective buffer around each of their respective pKa values. A diacid, such as tartaric acid, with pKa values of 2.96 and 4.24, can be an effective buffer within about 1 pH unit of each pKa value. A triacid, such as citric acid, can also form an effective buffer around its 3 pKa values, 3.13, 4.76 and 6.94. Since these values are so close to each other, the effective overall buffering range of citric acid is about 4 - 7.5.

Many varieties of formulations have been shown to be effective in cleaning semiconductor devices. These formulations include solvent based, amine based, semi-aqueous, and fluoride containing. With continued emphasis, within this discipline, on containing costs and minimizing employee exposure to hazardous chemicals, effective environmentally friendlier water-based etch residue removers have been devised and are the subject of the present invention.

### SUMMARY OF THE INVENTION

The present invention provides an aqueous and semi-aqueous etch residue removal/cleaning composition useful in removing etch residues from semiconductor wafers without damaging the underlying substrate . The compositions are also useful as cleaners for wafer processing equipment. The aqueous compositions are comprised of a water soluble organic polycarboxylic acid, a non- metal base in proportion to the acid to form an effective buffer, a fluoride source and water. The semi-aqueous compositions are comprised of an organic polyprotic carboxylic acid, a non-metal base in proportion to the acid to form an effective buffer, a fluoride source, water, and a water miscible organic solvent. In addition, both the aqueous and semi-aqueous compositions may optionally contain multiple additives such as, chelating agents, surfactants and corrosion inhibitors. A description and functional of such additives is disclosed in co-pending application U.S. Publication No. 2006/0172906. The description of which is incorporated herein by reference. The products comprising the composition of the invention are free of hazardous or toxic properties.

### BRIEF DESCRIPTION OF THE FIGURES

FIG. lA illustrates a typical wafer containing etch residue and with the vias clogged with etch and ash residue before cleansing.

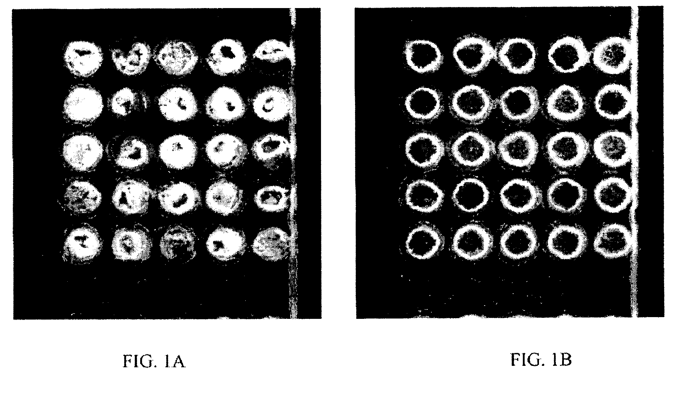

FIG. 1B illustrates the cleansed wafer of FIG. 1A in which the etch residue has been removed leaving vias free of the residue.

### DETAILED DESCRIPTION OF THE INVENTION

As hereinabove noted, the aqueous compositions of the invention provide more highly effective water-based semiconductor residue cleansing aqueous and semi-aqueous cleansing compositions comprising namely (A) an organic polycarboxylic acid, a non-metal base in proportion to the acid to form an effective buffer, a fluoride source and water, whereas the semi-aqueous compositions comprise; and (B) an organic polycarboxylic acid, a non-metal base in proportion to the acid to form an effective buffer, a fluoride source, water, and a water miscible organic solvent. Both the aqueous and semi-aqueous compositions A and B may optionally contain a chelating agent, surfactant or corrosion inhibitor.

The invention contemplates the provision of compositions of A and B that comprise variable proportions of the prescribed components such as the propositioned shown by the illustrated examples summarized in Table 1.

In addition to ammonium fluoride, the fluoride source utilized may comprise various other fluorides known to those skilled in the art as suitable alternatives to ammonium fluoride including various tetraalkylammonium fluorides such as, tetramethylammonium fluoride, and tetrabutylammonium fluoride, and hydrofluoric acid and fluoroboric acid.

In some of the formulations summarized in Table 1, where the solubility of components in a matrix are found to be problematic, solubility is usually enhanced by the addition of an organic cosolvent. The semi-aqueous formulations can be useful in more efficiently removing a variety of etch residue where the aqueous formulations are less effective.

The invention formulations, including those set forth in Table 1, are prepared by combining the components in their prescribed ratios in a non reactive plastic container and then stirring the mixture until complete dissolution results which usually occurs within a few minutes. When preparing quantities greater than 1 gallon, it may be advantageous to add water as the first component, followed by the gradual addition of each of the other solid components to prevent clumping and enhance dissolution. In most cases, some exotherm may be observed, due to the reaction of a weak acid and a weak base. Normally, external cooling is not required to control any temperature increase.

Etch rates utilizing the cleaning formulation of the invention were determined using a Mitsubishi Loresta AP Super-Intelligent Resistivity Meter Model MCP T400. As a specific example, identified at reference in Table 1 as No. 6, 1000 grams of cleaning formulation was prepared as described above. Thickness of a blanket wafer segment (size = 1.5 x 1.5 in.) was determined initially, and the wafer segment was then immersed in about 400 mL of formulation, stirred at 400 rpm on a magnetic stir plate at a prescribed temperature for 10 minutes. The wafer segment was then rinsed with water, dried and the thickness was measured again. To ensure accuracy, three separate samples were tested and the results averaged. The etch rate was then determined by dividing the average change in thickness by 10.

To evaluate the cleansing effectiveness, several gallons of formulation identified in Table 1 as No. 6 were loaded into an SEZ Zincillator single wafer tool. A patterned copper/ CORAL wafer segment (about 2 x 2 in.) was secured, by means of two-sided tape, to a blanket 8 in. silicon dioxide wafer at the center. The blanket wafer then was secured to a chuck, which was spun at about 500 rpm. Formulation No. 6 was then applied to the spinning wafer segment in a continuous stream for times ranging from 30 sec. to 120 sec. at 27 degrees centigrade. The wafer segment was then rinsed with distilled water and dried under a stream of nitrogen gas. Analysis of the cleaned wafer segment by a high resolution Scanning Electreon Microscope showed the pattern to be free of residue, in comparison to the uncleaned wafer segment. A detailed analysis of the cleaned wafer showed that there was minimal loss of underlying copper or Coral dielectric material. Table 1 is a compilation of various useful compositions within the contemplation of the invention.

**Table 1: Formulations as weight %**

| **Component** | **1** | **2** | **3** | **4** | **5** | **6** | **7** | **8** | **9** | **10** | **11** | **12** | **13** | **14** | **15** | **16** | **17** |
|---|---|---|---|---|---|---|---|---|---|---|---|---|---|---|---|---|---|
| tartaric acid | 2 | 2 | 2 | 2 | ∼ | ∼ | ∼ | ∼ | ∼ | ∼ | 2 | 2 | 2 | ∼ | ∼ | ∼ | ∼ |
| citric acid | ∼ | ∼ | ∼ | ∼ | 2 | 2 | 2 | 2 | 2 | 2 | ∼ | ∼ | ∼ | 2 | 20 | 2 | 2 |
| monoethanolamine | 1.8 | 1.5 | 0.85 | ∼ | 1.44 | 1.44 | 0.5 | 0.5 | 1.8 | 1.8 | 1.8 | 1.8 | 1.8 | 1.8 | 14.4 | 1.8 | 1.8 |
| 40% ammonium fluoride | 2 | 2 | 2 | 2 | 2 | 5 | 2 | 5 | 2 | 5 | 2 | 2 | 2 | 2 | 50 | 2 | 2 |
| water | 94.2 | 94.5 | 95.15 | 96 | 94.56 | 91.56 | 95.5 | 92.5 | 94.2 | 91.2 | 30 | 30 | 30 | 30 | 15.6 | 40 | 40 |
| dimethylacetamide | ∼ | ∼ | ∼ | ∼ | ∼ | ∼ | ∼ | ∼ | ∼ | ~ | 64.2 | ∼ | ∼ | 64.2 | ∼ | 54.2 | ∼ |
| Dipropyleneglycoldimethyl ether | ∼ | ∼ | ∼ | ∼ | ∼ | ∼ | ∼ | ∼ | ∼ | ∼ | ∼ | 64.2 | ∼ | ∼ | ∼ | ∼ | ∼ |
| tetramethoxy propane | ∼ | ∼ | ∼ | ∼ | ∼ | ∼ | ∼ | ∼ | ∼ | ∼ | ∼ | ∼ | 64.2 | ∼ | ∼ | ∼ | ∼ |
| NMP | ∼ | ∼ | ∼ | ∼ | ∼ | ∼ | ∼ | ∼ | ∼ | ∼ | ∼ | ∼ | ∼ | ∼ | ∼ | ∼ | 54.2 |

Considering the desired criteria of minimal etching and efficient cleaning, the formulations 5, 6, 9, 10, 11, 15, 16 and 17 were found to be useful, with those of examples 6, 15 and 17 listed in Table 1 showing the initial pH and the pH over a 10 day period. This data is significant because during the cleaning process of semiconductor devices, exposed metals and dielectrics are sensitive to changes in pH. In the case of formulations containing fluoride, etch rate is a function of pH. A formulation with a lower drifting pH will likely etch sensitive dielectrics faster, resulting in an inconsistent or undesirable result from batch to batch or even from wafer to wafer.

**Table 2: pH over 10 days**

| **Formulation #** | **5** | **6** | **7** | **8** | **9** | **10** |
|---|---|---|---|---|---|---|
| t = 0 pH | 5.5 | 5.5 | 4.2 | 5 | 6.2 | 6.1 |
| t = 10 days pH | 5.5 | 5.6 | 4.2 | 5.1 | 6.2 | 6 |

Table 3 demonstrates the etch rates of formulations selected from those sampled in Table 1 on a variety of substrates of the kind typically used for semiconductor fabrication. Desirable compositions contemplated by the invention are those formulations that have a minimal attack on the wafer substrate.

**Table 3: Etch Rates in angstroms/minute**

| **Substrate** | **Temp.(C)** | **5** | **6** | **7** | **8** | **9** | **10** |
|---|---|---|---|---|---|---|---|
| **doped (1) TEOS (2)** | 25 | 1 | 10 | 47 | 113 | 0 | 2 |
| | 40 | 2 | 20 | 117 | 293 | 2 | 2 |
| **OSG (3)** | 25 | 0 | 0 | 0 | 2 | 0 | 0 |
| | 40 | 0 | 0 | 2 | 4 | 0 | 1 |
| **SiN (4)** | 25 | 2 | 1 | ∼ | ∼ | 0 | 1 |
| | 40 | 6 | 5 | ∼ | ∼ | 0 | 2 |
| **SICN (5)** | 25 | 2 | 1 | ∼ | ∼ | 0 | 0 |
| | 40 | 3 | 2 | ∼ | ∼ | 0 | 2 |
| **Cu (6)** | 25 | 2 | 2 | ∼ | ∼ | 6 | 2 |
| | 40 | 2 | 2 | ∼ | ∼ | 7 | 5 |

| | | | | | | | |
|---|---|---|---|---|---|---|---|
| (1) Typical doping agents include, boron and phosphorous; (2) TEOS = tetraethylorthosilicate; (3) OSG = organosilicate glass; (4) SiN = silicon nitride; (5) SiCN = silicon carbon nitride; and (6) Cu = copper | | | | | | | |

Although the invention has been described in terms of specific tests and embodiments, one skilled in the art can substitute other known tests and embodiments based on the teaching provided and they are meant to be included herein. Accordingly, the invention is only to be limited by the scope of the appended claims.

## Claims

1. A cleansing composition for semiconductor devices, selected from aqueous and semi-aqueous compositions, comprising: (a) from about 0.5 to about 20 percent of an organic water soluble polyprotic carboxylic acid; (b) a metal free base in proportion to form an effective buffer with above acid; (c) from about 20 to about 95 percent water; (d) from about 0 to about 60 percent of a water miscible organic solvent; and (e) from about 0.25 to about 5 percent of a fluoride source.

2. An aqueous cleansing composition for semiconductor devices, in accordance with claim 1, comprising: (a) from about 0.5 to about 20 percent of an organic water soluble polyprotic carboxylic acid; (b) a metal free base, in proportion to form an effective buffer with the above acid; (c) about 20 to about 95 percent water; and (d) about 0.25 to about 5 percent of a fluoride source.

3. A semi-aqueous cleansing composition for semiconductor devices, in accordance with claim 1, comprising: (a) about 0.5 to about 20 percent of an organic polyprotic carboxylic acid; (b) a metal free base in proportion to form an effective buffer with the above acid; (c) about 20 - 60 percent water; (d) about 30 - 60 percent water miscible organic solvent; and (e) about 0.25 to about 5 percent of a fluoride source.

4. The cleansing composition of claim 2 wherein the water soluble polycarboxylic acid is selected from citric acid and tartaric acid and the fluoride source in ammonium fluoride.

5. The cleansing composition of claim 2 containing an additive selected from a metal corrosion inhibitor and a chelating agent.

6. The cleansing composition of claim 2 incorporating a surfactant.

7. The cleansing composition of claim 4 wherein the water soluble polyprotic carboxylic acid is selected from citric acid and tartaric acid.

8. The semi-aqueous cleansing composition of claim 3 containing an additive selected from a metal corrosion inhibitor and a chelating agent.

9. The semi-aqueous cleansing composition of claim 3 incorporating a surfactant.

10. The semi-aqueous cleansing composition of claim 3, wherein the polycarboxylic acid is tartaric acidand the metal free base is monoethanolamine and the fluoride source is ammonium fluoride.

11. The semi-aqueous cleaning formulation of claim 5, wherein the organic polyprotic carboxylic acid is citric acid, and the formulation contains from about 0.5-20% percent monoethanolamine, and from about 0.25 to about 3 percent ammonium fluoride as the fluoride source.

12. The aqueous cleansing composition of claim 10, wherein the polyprotic carboxylic acid is tartaric acid and is present in amounts from about 0.5 to about 5 percent, the metal free base is monoethanolamine and the ammonium fluoride is present in amounts of from about 0.25 to about 3 percent.

13. The aqueous cleansing composition of claim 10, wherein the polycarboxylic acid is citric acid.

14. A method of preparing semiconductor etch residue cleaning formulation selected from aqueous and semi-aqueous compositions the steps comprising: (a) introducing into a reaction vessel from about 0.5 to about 20 percent of an organic water soluble polyprotic carboxylic acid and a metal free base in proportion to form an effective buffer with said acid; (b) introducing from about 20 to about 95 percent water into said reaction vessel; and (c) adding at a rate with stirring to prevent clumping from about 0 to about 60 present of a water miscible organic solvent from about 0.25 to about 5 percent of a fluoride source.

15. A method of preparing an aqueous cleaning formulation for semiconductor devices in accordance with claim 14, comprising: (a) introducing about 0.5 to about 20 percent of a mixture of an organic water soluble polyprotic carboxylic acid with the metal free base in proportion to form an effective buffer with said acid into the reaction vessel containing from about 20 to about 25 percent water; and (b) from about .025 to about 5 percent of a fluoride source and reacting said mixture.

16. A method of preparing a semi-aqueous cleaning formulation for semiconductor devices in accordance with claims 14, comprising: (a) introducing about 0.5 to about 20 percent of a mixture of an organic polyprotic carboxylic acid with the metal free base in proportion to form an effective buffer with the acid into the reaction vessel containing from about 20 - 60 percent water; (b) about 30-60 percent water miscible organic solvent; and (c) about 0.25 to about 5 percent of a fluoride source and stirring said mixture until homogeneous.
